Europäisches Patentamt

European Patent Office

Office européen des brevets

(19)

(11) Numéro de publication: **0 292 345**
**A2**

## DEMANDE DE BREVET EUROPEEN

(21) Numéro de dépôt: 88401020.8

(22) Date de dépôt: 26.04.88

(51) Int. Cl.4: **H 03 K 17/80**
**H 03 K 3/53**

(30) Priorité: 28.04.87 FR 8706015

(43) Date de publication de la demande:
**23.11.88 Bulletin 88/47**

(84) Etats contractants désignés: **DE FR GB NL**

(71) Demandeur: **COMMISSARIAT A L'ENERGIE ATOMIQUE**
**31/33, rue de la Fédération**
**F-75015 Paris (FR)**

(72) Inventeur: **Roche, Michel**
**12, rue Saulx-Tavannes**
**F-21000 Dijon (FR)**

**Raboisson, Gérard**
**1, rue Jean Sans Peur Chevigny Saint Sauveur**
**F-21800 Quetigny (FR)**

(74) Mandataire: **Mongrédien, André et al**
**c/o BREVATOME 25, rue de Ponthieu**
**F-75008 Paris (FR)**

(54) Générateur d'impulsions électriques du type à inductance saturable.

(57) Générateur d'impulsions électriques comprenant au moins un condensateur réalisé sous forme d'un tronçon de ligne coaxiale et une inductance saturable servant de commutateur. Selon l'invention, l'inductance saturable (46) est disposée à l'intérieur du conducteur intérieur de la ligne coaxiale (43, 44).

Application à la formation d'impulsions électriques de forte puissance.

FIG.4

EP 0 292 345 A2

Bundesdruckerei Berlin

## Description

# GENERATEUR D'IMPULSIONS ELECTRIQUES DU TYPE A INDUCTANCE SATURABLE

La présente invention a pour objet un générateur d'impulsions électriques du type à inductance saturable.

Un moyen pour augmenter la puissance d'une impulsion électrique consiste à réduire considérablement sa durée sans trop affecter son amplitude. Une telle compression peut être obtenue selon un principe mis au point au "Lawrence National Livermore Laboratory" des Etats-Unis d'Amérique, et décrit notamment dans IEEE Transaction on Nuclear Service, vol. NS-32, n°5, octobre 1985.

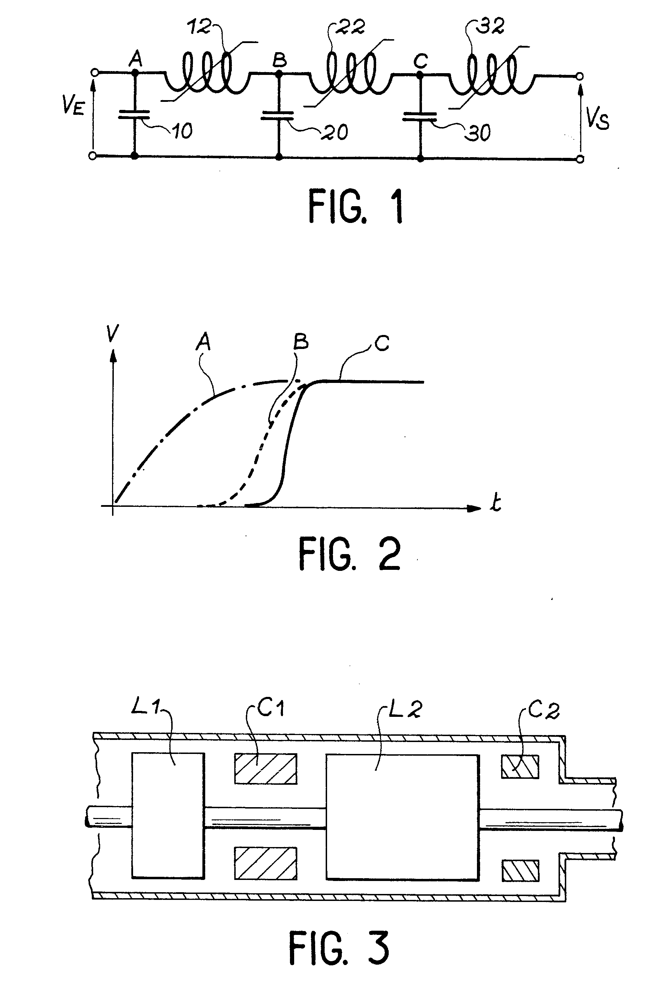

Un générateur d'impulsions de ce type comprend une série de condensateurs reliés entre eux par des inductances saturables. Le schéma d'un tel générateur est représenté sur la figure 1 : des condensateurs 10, 20, 30 alternent avec des inductances saturables 12, 22, 32. Une impulsion de tension VE est appliquée à l'entrée, au point A, et charge le condensateur 10. Cette impulsion est constituée par exemple par une arche de sinusoïde. L'inductance 12 est d'abord de forte valeur, et s'oppose à la décharge du condensateur ; mais lorsque le condensateur 10 est chargé, le courant de décharge augmente et la valeur de l'inductance chute ; l'énergie électrique se propage alors vers la droite où le même mécanisme se reproduit dans la cellule condensateur 20- inductance 22 et ainsi de suite.

La figure 2 montre le raidissement progressif du front de montée de l'impulsion de tension lorsqu'on passe du point A aux points B et C de la ligne.

Dans la pratique, on connaît des générateurs de ce type qui sont constitués comme indiqué sur la figure 3. Un tronçon de ligne coaxiale L1 constitue le condensateur; il est suivi d'un commutateur C1 à inductance saturable. Un second tronçon de ligne L2 est suivi d'un second commutateur C2.

Un mode de réalisation particulier utilisant trois anneaux de ferrite constituant les inductances saturables et quatre condensateurs comprenant chacun un tronçon de cylindre en céramique ferroélectrique est décrit également dans l'article de YU V. MAKRITSKII intitulé "Generator of Current Pulses with Sharp Leading Edge" publié dans la revue "Instruments and Experimental Technics", vol 20, n°1/1, 02.01, 1977, pp. 130-132.

Bien que donnant satisfaction à certains égards, de tels dispositifs présentent cependant des inconvénients qui tiennent la multiplication des interfaces ligne-commutateur. Ces dispositifs sont donc complexes et coûteux. Par ailleurs, ils posent des problèmes de tenue de tension.

Le but de la présente invention est justement de remédier à cet inconvénient. A cette fin, l'invention préconise une structure beaucoup plus compacte, qui facilite en outre les problèmes de tenue en tension. Par ailleurs, la structure de l'invention permet l'utilisation de lignes à eau qui sont beaucoup plus simples que les lignes à huile utilisées dans l'art antérieur. En ce qui concerne les performances électriques obtenues, les impulsions engendrées ont des fronts plus raides que dans l'art antérieur et un sommet plus plat. Par ailleurs, le rendement électrique se trouve amélioré.

Il faut ajouter que l'on connaît d'autres moyens pour modifier la forme d'une impulsion électrique et plus précisément pour modifier le front de montée d'un échelon de tension. Le raidissement d'un front peut s'obtenir par une ligne de propagation de type coaxial, tout au long de laquelle des anneaux de ferrite présentant un cycle d'hystérésis non rectangulaire sont répartis. On peut compter ainsi 6000 anneaux de ferrite. Un échelon de tension à front progressif appliqué à l'entrée de la ligne donne naissance à une onde qui se propage le long de la ligne avec raidissement progressif du front. La ligne délivre alors un échelon de tension à front raide.

Un tel dispositif est décrit par exemple dans l'article de V.A. SHVETS intitulé "Nonlinear Multichannel Pulse-Sharpening line containing Ferrite Rings with Nonrectangular Hysteresis Loop" publié dans la revue "Instruments and Experimental Technics", vol.25, (1982), July-August n°4, Part 1, pp. 908-912.

De tels dispositifs ne constituent pas à proprement parler des "générateurs" d'impulsions, mais plutôt des raidisseurs de front. Par ailleurs, ils ne mettent pas en oeuvre le mécanisme de charge d'un condensateur puis de décharge dans un autre condensateur à travers une inductance saturable. On peut donc difficilement comparer les fonctions électriques de ces deux familles de dispositifs.

De façon précise, l'invention a pour objet un générateur d'impulsions électriques comprenant au moins un condensateur réalisé sous forme d'un tronçon de ligne coaxiale formé d'un conducteur extérieur et d'un conducteur intérieur et au moins une inductance saturable servant de commutateur et disposée entre deux condensateurs, ce générateur étant caractérisé par le fait qu'au moins une inductance saturable est disposée à l'intérieur du conducteur intérieur d'un tronçon de ligne coaxiale servant de condensateur.

Selon un premier mode de réalisation, l'inductance saturable comprend une seule spire en forme de tore. Mais elle peut être réalisée également par une ou plusieurs spires enroulées autour d'un noyau magnétique.

De toute façon, les caractéristiques de l'invention apparaîtront mieux à la lumière de la description qui suit. Cette description se réfère à des dessins annexés sur lesquels :

    - la figure 1, déjà décrite, représente le schéma électrique d'une ligne à compression d'impulsion,

    - la figure 2, déjà décrite, montre des formes de tensions en divers points de la ligne précédente,

    - la figure 3, déjà décrite, montre un générateur de l'art antérieur,

    - la figure 4 montre un premier exemple de réalisation de l'invention,

    - la figure 5 montre un deuxième exemple de réalisation de l'invention,

- la figure 6 montre l'allure de tensions prises en divers points du dispositif précédent,

- la figure 7 montre un troisième exemple de réalisation de l'invention,

- la figure 8 montre l'évolution des tensions dans le cas précédent,

- la figure 9 montre un autre mode de réalisation de l'invention.

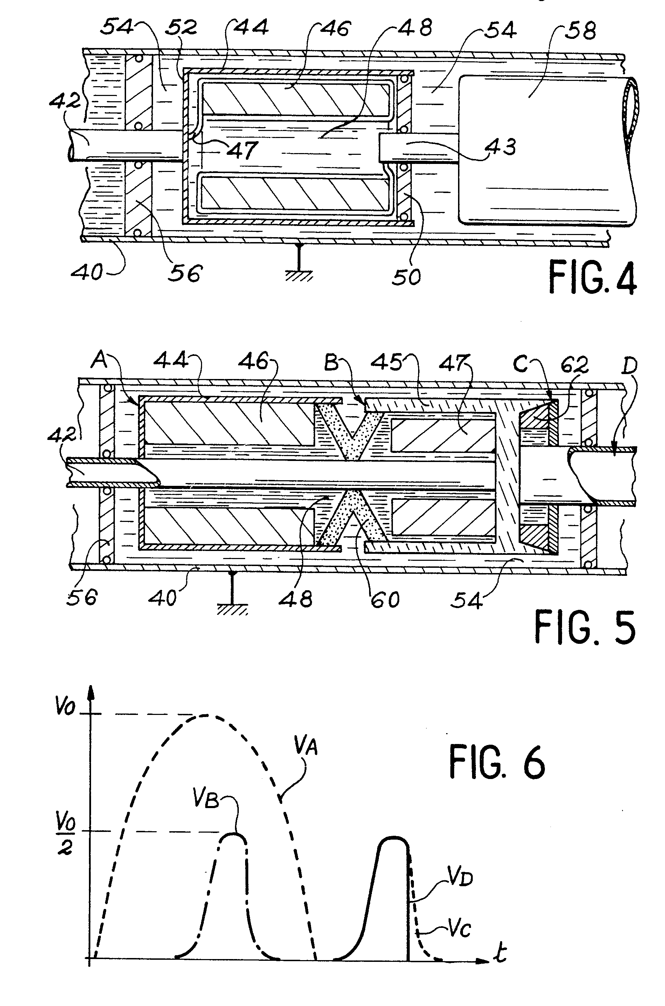

Sur la figure 4, on voit une enceinte extérieure 40 reliée à la masse et un conducteur central 42 d'alimentation. Le tronçon de ligne coaxiale constituant le condensateur est formé par un conducteur cylindrique intérieur 44 et par la partie en regard de l'enveloppe extérieure 40. A l'intérieur du cylindre 44 se trouve une inductance saturable constituée, par exemple, par un noyau 46 en forme de tore en matériau ferromagnétique (ferrite ou tôles suivant la fréquence de fonctionnement) et par un enroulement 47. Le volume intérieur au cylindre est rempli d'huile 48. L'étanchéité est assurée par un disque isolant 50 et par le fond 52 du cylindre 44. Extérieurement, l'ensemble baigne dans un liquide diélectrique 54, par exemple de l'eau désionisée. L'étanchéité est assurée par un bouchon isolant 56. L'enroulement 47 relie le fond 52 à un conducteur intérieur 43.

La sortie électrique est constituée par une ligne coaxiale formée d'un conducteur intérieur 58 relié au conducteur 43, et d'un conducteur extérieur constitué par l'enceinte externe 40.

Le cylindre 44 et le conducteur 43 peuvent être réalisés en inox.

Sur les figures suivantes, l'inductance saturable est représentée de manière plus schématique, sans qu'apparaisse nécessairement le conducteur bobiné autour du noyau lorsqu'un tel conducteur existe.

Le matériau magnétique constituant le tore 46 est de préférence un matériau ferromagnétique à cycle rectangulaire, comme par exemple un fer-silicium à grains orientés ou certains alliages de nickel (comme l'alliage de la marque RECTIMPHY) ou encore certains des alliages amorphes.

La figure 5 représente une variante de réalisation dans laquelle on utilise un deuxième tronçon de ligne coaxiale constitué par un conducteur intérieur 45 et la partie correspondante de l'enceinte extérieure 40. A l'intérieur du conducteur intérieur 45 se trouve un deuxième tore magnétique 47. Une pièce étanche 60 isole les volumes intérieurs de ces deux lignes.

Une ultime inductance saturable 62, toujours disposée à l'intérieur du conducteur intérieur 45, peut terminer l'ensemble.

Les points A, B, C et D marquent quatre emplacements particuliers du dispositif. L'évolution de la tension en ces points est représentée sur la figure 6 en supposant qu'on applique à l'entrée une arche de sinusoïde d'amplitude Vo (tension en A). Les tensions disponibles en B, C et D ont l'amplitude Vo/2.

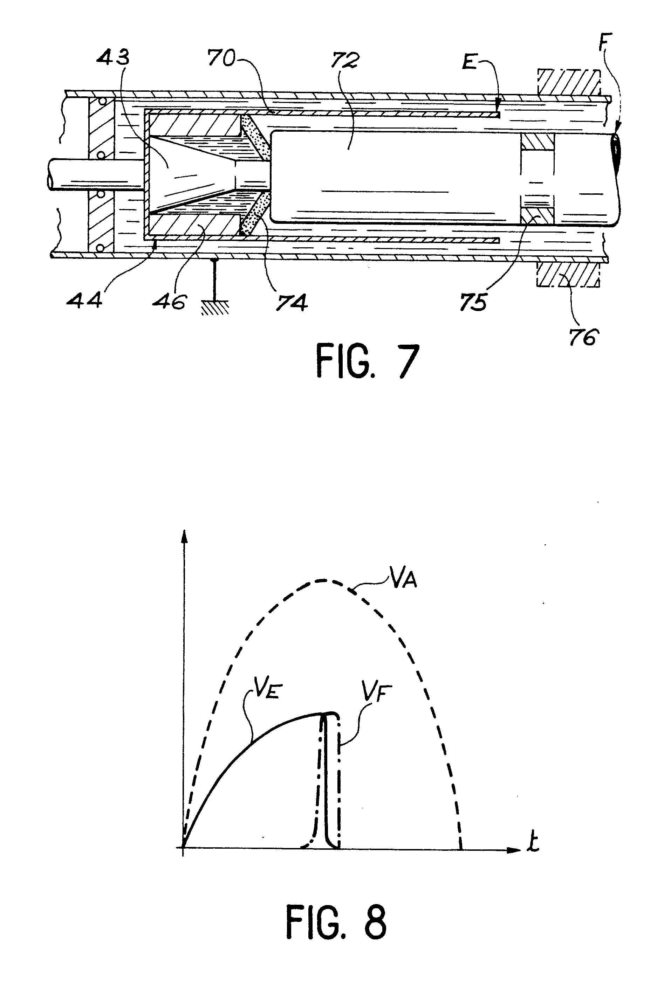

Sur la figure 7, le dispositif se prolonge par une ligne coaxiale dite de BLUMLEIN. Cette ligne comporte deux cylindres 70, 72, le premier relié au conducteur intérieur 44 constituant le tronçon de ligne coaxiale correspondant au condensateur et le second au conducteur tronconique intérieur 43. Une pièce tronconique 74 assure l'étanchéité à l'huile. Une inductance saturable 75 peut être placée en bout de ligne pour constituer un commutateur raidisseur de front avant. Ce commutateur peut aussi être placé en 76 à l'extérieur de la ligne.

La figure 8 illustre les formes des tensions apparaissant aux points E et F, c'est-à-dire à l'extrémité de la double ligne et après le dernier commutateur.

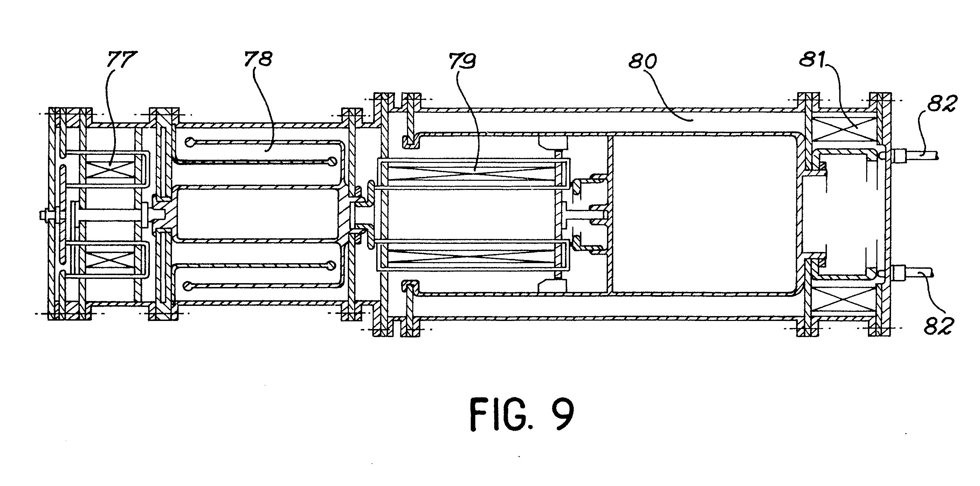

Selon un autre mode de réalisation de l'invention illustré sur la figure 9 un transformateur 77 délivre une impulsion permettant de charger un condensateur à eau 78 constitué par au moins deux cylindres coaxiaux. Ce condensateur est relié à une inductance saturable 79 comportant un ou plusieurs tours bobinés autour d'un noyau ferromagnétique présentant un cycle d'hystérésis aussi rectangulaire que possible. Cette inductance est placée à l'intérieur du conducteur intérieur du tronçon de ligne 80, de telle sorte qu'elle permette d'alimenter cette ligne par son centre. De cette façon la capacité de la ligne coaxiale 80 est reliée au condensateur 78 par une inductance saturable 79 ce qui constitue une cellule de compression magnétique selon le principe de la figure 1.

La ligne 80 constitue en outre une ligne de mise en forme permettant d'obtenir en sortie, sur une série de câbles coaxiaux 82, reliés en parallèle sur l'extrémité de la ligne 80, une impulsion rectangulaire étroite. Les âmes des câbles 82 passent l'intérieur du noyau 81, qui introduit une inductance série saturable dont le fonctionnement peut s'apparenter à un commutateur magnétique. Ainsi, dès que la saturation du noyau 81 est atteinte la ligne 80 se décharge dans les câbles 82 dont l'impédance équivalente est déterminée de façon à être voisine de celle de la ligne 80.

On peut ainsi obtenir des impulsions rectangulaires de plusieurs centaines de kilovolts, ayant des durées de plusieurs dizaines de nanosecondes.

**Revendications**

1. Générateur d'impulsions électriques comprenant au moins un condensateur réalisé sous forme d'un tronçon de ligne coaxiale avec un conducteur extérieur (40) et un conducteur intérieur (44) et au moins une inductance saturable servant de commutateur et disposée entre deux condensateurs, caractérisé par le fait qu'au moins une inductance saturable (46, 47) est disposée à l'intérieur du conducteur intérieur (44) d'un tronçon de ligne coaxiale servant de condensateur.

2. Générateur selon la revendication 1, caractérisé par le fait que l'inductance saturable comprend une seule spire en forme de tore.

3. Générateur selon la revendication 1, caractérisé par le fait qu'il comprend un premier tronçon de ligne coaxiale (40, 44) avec une première inductance saturable (46) à l'intérieur du conducteur intérieur (44) et un second tronçon de ligne coaxiale (40, 45) avec une seconde inductance (47) à l'intérieur du conducteur intérieur (45), ces deux tronçons de ligne coaxiale ayant leur conducteur intérieur (44, 45) relié à un même conducteur central (42).

4. Générateur selon la revendication 1, caractérisé par le fait qu'il comprend un premier tronçon de ligne coaxiale (40, 44) avec une première inductance saturable (46) située à l'intérieur du conducteur intérieur (44) et une ligne de transmission de type double constituée d'un premier conducteur cylindrique (70) relié au conducteur intérieur (44) du premier tronçon de ligne coaxiale et un second conducteur cylindrique (72) coaxial au premier et relié par un conducteur intérieur (43) au premier tronçon de ligne coaxiale.

5. Générateur selon la revendication 1, caractérisé par le fait que le volume intérieur du tronçon de ligne baigne dans de l'huile (48) et que le tronçon de ligne dans son ensemble baigne dans un liquide isolant, par exemple de l'eau (54), des moyens étanches et électriquement isolants (50, 56, 60, 74) étant prévus pour isoler l'intérieur du conducteur intérieur (44) et l'extérieur dudit conducteur intérieur (44).

6. Générateur selon la revendication 1, caractérisé par le fait qu'il comprend un premier condensateur (78) relié à un second condensateur (80) par une inductance saturable (79) disposée à l'intérieur du conducteur intérieur de la ligne (80) constituant ce second condensateur.

0292345

FIG. 1

FIG. 2

FIG. 3

0292345

FIG.4

FIG. 5

FIG. 6

0292345

FIG. 7

FIG. 8

FIG. 9